Europäisches Patentamt

(19) European Patent Office

Office européen des brevets

(11) Publication number : **0 463 871 A2**

# (12) EUROPEAN PATENT APPLICATION

(21) Application number : **91305794.9**

(22) Date of filing : **26.06.91**

(51) Int. Cl.⁵ : **G06K 19/06,** G07F 19/00, H04M 17/02

(30) Priority : **29.06.90 GB 9014545**

(43) Date of publication of application : **02.01.92 Bulletin 92/01**

(84) Designated Contracting States : **AT BE CH DE DK ES FR GB GR IT LI LU NL SE**

(71) Applicant : **GEC AVERY LIMITED Smethwick Warley, West Midlands, B66 2LP (GB)**

(72) Inventor : **Jarvis, Charles Richard 12 Acacia Avenue, Bewdley Warley, West Midlands B66 2LP (GB)**

(74) Representative : **Loven, Keith James et al GEC Patent Department, GEC Marconi Limited, West Hanningfield Road Great Baddow Chelmsford, Essex CM2 8HN (GB)**

(54) Integrated circuit token.

(57) An integrated circuit token, for example of the smart card type, comprises a substrate (11) having an aperture (12) in which fits an integrated circuit die (13) which is wire bonded (14) to the substrate. An aluminium foil (15) extends over a portion of the undersurface of the substrate to close the aperture, support the die and act as a heat sink.

Fig 2

EP 0 463 871 A2

This invention relates to an integrated circuit token. Such a token may, for example, be in the form of a flexible card of the shape and dimensions of a conventional credit card. Such tokens are sometimes referred to as 'Smart Cards', and may be used for data storage and processing purposes, e.g. for transactions such as bank account transactions, for security access or identification purposes, and for many other purposes.

In the type of token to which the invention is particularly, but not exclusively, related, electronic circuitry is embedded within a flexible card structure, mounted on a substrate and then encapsulated by a plastics material which forms the overall dimensions of the card. In one system, the card communicates with an external coupler by means of magnetic loops embedded within the card structure and thus there are no electrical contacts on the external surface of the card. It is essential that the substrate which lies within the plastics material and which supports the circuitry is as thin as possible. Initially, the substrate was formed of an epoxy resin material which needs to be relatively thick to give it sufficient strength. Components, such as integrated circuits, are then bonded on top of the epoxy resin substrate and wire bonded from their top surface to contacts on the electrical circuitry provided on the surface of the substrate. The component is then encapsulated in a "glob top" hardenable plastics material applied in liquid form, so as to protect it before being encapsulated in a further plastics material which forms the card itself. Such systems are relatively bulky and cannot meet the maximum thickness requirement of conventional credit cards, of the magnetic stripe type, for example.

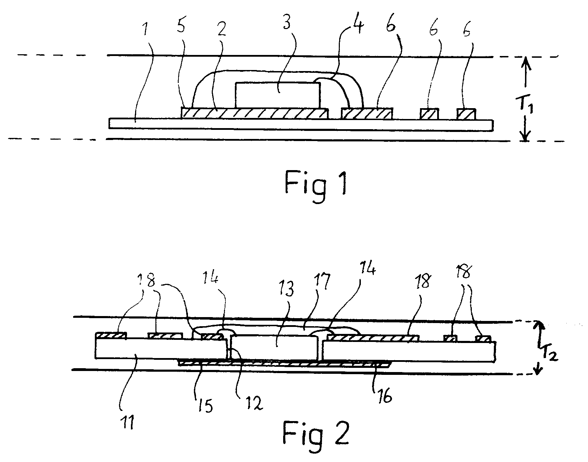

Figure 1 shows a first attempt to make the card thinner, in which the substrate 1 on which the components are mounted is a thin film structure made of, typically, polyimide, polyester or epoxy glass. A copper layer 2 is laid down on top of the film and the integrated circuit or circuits 3 are mounted on top of the copper layer and wire bonded 4 to electrical interconnections 6 defined in the copper layer 2. The copper layer is provided with a plurality of conductive pads 5 which act as heat sinks for the circuit 3. Although this has resulted in thinner cards due to the thin polyimide or polyester film it is difficult to wire bond to such a film due to its resilient rubbery nature.

In US-A-4755661 there is disclosed a token of the general type with which the invention is concerned, in which the integrated circuit component is mounted within an aperture in the substrate, but on a plastic film layer extending through from the reverse of the substrate. The film layer has a metal layer on one face and conductive tracks on the opposite face, and through connectors are required. The resultant structure is complex, and difficult to manufacture.

According to the present invention there is provided an integrated circuit token comprising a flexible substrate encased within a plastics body, the substrate bearing electrical circuit elements on at least one face thereof and mounting an integrated circuit component, the substrate having an aperture therethrough, the aperture being closed at one face of the substrate by a metal foil element adhered to a part of one face, and the integrated circuit component being adhered to the metal foil element within the aperture and electrically connected by wires extending from said integrated circuit and bonded to electrical circuit elements on the face of the substrate opposite to that said one face.

Preferably the metal foil element is an aluminium foil.

The wire bonded integrated circuit can be covered by a "glob top" resin and the entire insert which preferably includes one or more magnetic coils for inductive coupling, can then be encapsulated within a flexible plastics material so as to form a Smart Card or similar structure.

The substrate is typically of an epoxy resin material.

An embodiment of the invention will now be described by way of example only with reference to the accompanying drawings in which Figure 2 shows a schematic cross-section through a flexible card showing an insert according to the present invention.

Referring to Figure 2, the insert for a Smart Card or similar flexible card comprises a substrate board 11 which is made of an epoxy resin. An aperture 12 is provided within the board of suitable size to receive an integrated circuit die 13. The aperture is preferably of such a size that the component fits snugly within it although the height of the component may or may not be the same as the depth of the aperture. A thin conductive film 15, preferably of aluminium, is attached by means of an adhesive layer 16 to the underside of the die 13. This serves two purposes; firstly to secure the die to the substrate and secondly, by extending beyond the width of the die along the substrate, it also acts as a heat sink and thus avoids the need for separate heat sink pads as have been previously required in the prior art. The component may be located by adhesive to the sides of the aperture and to the surface of the film 15 and is electrically connected by wire bonds 14 to the substrate 11. The film 15 can be made very thin, perhaps 30 microns thickness and the component can be covered by a glob top plastics material 17 in order to protect it. The epoxy substrate may also support conductive tracks 18 and other components or magnetic coils.

The insert is then ready for being integrated into a finished card structure, which may be done by a lamination process or, more preferably, by a moulding process in which the insert, together with a mouldable plastics material, is inserted into a mould and in which the finished moulding is a flexible card structure having dimensions of a typical credit card. Strengthening supports may also be added to protect the circuitry from the effects of bending, and printed labels or skins will usually be included on the main faces of the card. The electronic component 13 is protected from temperature damage in operation by the heat-sink action of the film 15. It should also be noted that although the epoxy substrate is a relatively rigid unbendable structure the insert will only form a small portion of the length of the card and thus the card as a whole remains flexible.

It is seen from a study of Figures 1 and 2 that the thickness $T_2$ of the card according to the present invention may be less than the thickness $T_1$ of a prior art card. Furthermore, the component die 13 is better protected than the die in the prior art system due to its being supported at its sides by the substrate.

## Claims

1. An integrated circuit token, comprising a flexible substrate encased within a plastics body, the substrate (11) bearing electrical circuit elements on at least one face thereof and mounting an integrated circuit component (13), characterised in that the substrate has an aperture (12) therethrough, a metal foil element (15) is adhered to a part of one face of the insert so as to cover the aperture, and the integrated circuit component is adhered to the foil element within the aperture and electrically connected by wires (14) to electrical circuit elements on the face of the substrate opposite to that to which the foil element is adhered.

2. An integrated circuit token according to Claim 1, wherein the metal foil element (15) is aluminium foil.

3. An integrated circuit token according to Claim 1 or 2, wherein the flexible substrate mounts a plurality of integrated circuit elements, each said element being mounted in a separate aperture in the substrate and each said aperture being closed at one face of said substrate by a separate respective metal foil element.

4. An integrated circuit token according to Claim 3, wherein all of said metal foil elements are adhered to the same face of said substrate.

5. An integrated circuit token according to any preceding claim, wherein said metal foil element extends over said one face of the substrate only to an extent sufficient to underlie the bonds between said wires and said electrical circuit elements on said opposite face of said substrate.

6. An integrated circuit token according to any preceding claim, wherein said integrated circuit component is a close fit in said aperture.

7. An integrated circuit token according to any preceding claim, having a thickness substantially equal to that of a standard bank or credit card.

8. An integrated circuit token according to any preceding claim, having a body of a polymeric material coated over said aperture and said wire bonds before the substrate is encased with the plastics body.

Fig 1

Fig 2